(19) Europäisches Patentamt
European Patent Office
Office européen des brevets

(11) EP 1 062 702 B1

(12) **EUROPEAN PATENT SPECIFICATION**

(45) Date of publication and mention of the grant of the patent:
**19.05.2010 Bulletin 2010/20**

(21) Application number: **99906081.7**

(22) Date of filing: **02.03.1999**

(51) Int Cl.:
***H01L 41/107*** *(2006.01)*

(86) International application number:
**PCT/DK1999/000096**

(87) International publication number:
**WO 1999/045600 (10.09.1999 Gazette 1999/36)**

(54) **PIEZOELECTRIC TRANSFORMER**

PIEZOELEKTRISCHER TRANSFORMATOR

TRANSFORMATEUR PIEZO-ELECTRIQUE

(84) Designated Contracting States:
**AT BE CH DE DK ES FI FR GB GR IE IT LI NL SE**

(30) Priority: **03.03.1998 DK 28498**

(43) Date of publication of application:
**27.12.2000 Bulletin 2000/52**

(73) Proprietor: **Noliac A/S**
**3490 Kvistgaard (DK)**

(72) Inventor: **BREBØL, Klaus**
**DK-4772 Langebæk (DK)**

(74) Representative: **Hertling, Peter et al**
**Inspicos A/S**
**Kogle Allé 2**
**P.O. Box 45**
**2970 Hørsholm (DK)**

(56) References cited:
**DE-A1- 2 650 356**

- **PATENT ABSTRACTS OF JAPAN; & JP 9321363 A (NEC CORP) 12 December 1997.**
- **PATENT ABSTRACTS OF JAPAN; & JP 4167504 A (NEC CORP) 15 June 1992.**
- **PATENT ABSTRACTS OF JAPAN; & JP 9223826 A (MURATA MFG CO LTD) 26 August 1997.**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Technical Field.

The invention relates to a piezoelectric transformer comprising a piezoelectric body which is divided into a primary portion and a secondary portion, whereby both the primary portion and the secondary portion are able to generate and transform piezoelectric vibrations in accordance with an AC-voltage fed to one portion while a transformed voltage can be delivered from the other portion.

Background Art

A known piezoelectric transformer of this type comprises a piezoelectric body in form of an oblong plate having a mechanical resonance frequency. The transformer is preferably operated at this resonance frequency. However, this transformer is encumbered with the draw-back that further resonance frequencies may have an effect on the mode of operation of the transformer.

Furthermore, US-PS No. 3,736,446 discloses an annular transformer. The piezoelectric material is layered by means of through electrodes along a portion of the periphery of this transformer, said portion utilizing oscillations in the peripheral direction. As an alternative, a ring can be painted on the ceramics. This structure is encumbered with the draw-back that it is relatively expensive to manufacture. In addition, the resonance frequency is relatively low for oscillation types along the periphery. The transformable effect is proportional to the frequency. The effect transformable by means of this annular transformer is therefore relatively insignificant.

JP-A-09-321363 describes a columnar shape without a through-going opening in the longitudinal direction. It works in the longitudinal mode. As a result the resonance frequency is very low and the power density will be low also.

Brief Description of the Invention

The object of the invention is therefore to provide a piezoelectric transformer presenting a higher field intensity than hitherto known and which does not involve undesired resonance frequencies.

A piezoelectric transformer of the above type is according to the invention characterised in that the piezoelectric body is formed by a substantially oval or annular body which has been polarised substantially perpendicular to the peripheral direction. An annular piezoelectric body presents three basic modes of vibration, viz. the periphery presenting the lowest frequency and a planar and a thickness vibration presenting a comparatively higher frequency due to the reduced extent of the vital dimension. Therefore the annular transformer is according to the invention able to operate at a comparatively higher frequency as it operates on a thickness vibration instead of a peripheral vibration. Moreover, the geometry provides an increased capacity, which together with the increased operation frequency results in a reduced output impedance. Thus the transformer is able to handle increased currents, typically in the range of 0.1 to 5 A.

The power in the transformer is transferred as a mechanical vibration. The maximum allowed, transferred power depends on the fatigue strength of the ceramics. For a predetermined maximum mechanical strain in the ceramics the transferred power is

$$P = f_{res} \cdot \epsilon \cdot vol \cdot k_{eff}^2$$

where

P = transferred power
$f_{res}$ = resonance frequency
vol = volume
$k_{eff}$ = efficient piezoelectric coupling coefficient corresponding to the exist- ing mode of vibration
ε = dielectric permittivity

When two annular transformers are made of the same ceramics and with the same volume, the maximum allowable strain and e vol is constant. As previously mentioned, the resonance frequencies are higher for the thickness vibration than for the peripheral vibration, and as far as conventional piezoelectric ceramics of the power type is concerned, the associated coupling coefficients are 0.3 to 0.35 ($k_{31}$, peripheral vibration) and 0.40 to 0.45 ($k_T$, thickness vibration), respectively.

The difference in coupling coefficient results in an increased power density of

$$(0.45/0.35)^2 = 1.65$$

and the resonance frequency is typically a factor 10 higher. Totally, the power density is increased by 1.65·10 = 16.5.

Brief Description of the Drawing

The invention is explained in greater detail below with reference to the accompanying drawings, in which

Fig. 1 illustrates a piezoelectric transformer with an annular piezoelectric body on each side of an insulating plate,

Fig. 2 is a sectional view through the transformer of Fig. 1 and illustrating the vibrations,

Fig. 3 is a sectional view through the transformer of Fig. 1 and illustrating the electrode configurations,

Fig. 4 is a sectional view corresponding to the sectional view of Fig. 3. where one primary electrode has been moved away from the insulating layer so as to reduce the mechanical stresses due to the polarisation,

Fig. 5 is a sectional view corresponding to the sectional view of Fig. 3, but showing an alternative positioning of the primary electrodes,

Fig. 6 is a sectional view corresponding to the sectional view of Fig. 5, where the inner electrode has been withdrawn so as to reduce the polarisation stresses,

Fig. 7 illustrates an alternative embodiment of a piezoelectric transformer, where the annular piezoelectric body presents a wavy closed shape, and

Fig. 8 illustrates an alternative embodiment of a piezoelectric transformer, where the primary portion is quadrangular and presents a circular opening.

Best Mode for Carrying Out the Invention

The piezoelectric transformer illustrated in Fig. 1 comprises an annular piezoelectric body on each side of an insulating plate 1. One piezoelectric body 2 serves as primary portion whereas the other piezoelectric body 3 serves as secondary portion. Electrodes are provided both at the primary portion 2 and at the secondary portion 3, and both said primary portion and said secondary portion are able to generate and transform piezoelectric vibrations in response to an AC-voltage fed from one portion while the transformed voltage can be delivered from the other portion. According to the invention each piezoelectric body is formed by a substantially oval or annular body. As a result, an improved uniform distribution of the stresses, an increased coupling coefficient as well as improved cooling conditions are obtained. A vital factor for maximizing the efficient coupling is that b/h is either less than 0.25 or 0.35 < b/h < 0.8 or especially 0.4 < b/h < 0.7, where b represents the width and h represents the height.

Fig. 2 illustrates that the transformer operates as a semiwave resonator..

Fig. 3 illustrates an example of an electrode structure at both the primary portion and at the secondary portion. A circumferential electrode is provided on the primary portion both at the top side 4 and at the bottom side 5. The secondary portion is formed as a multilayer structure with inner electrodes 69, 66. These inner electrodes 69, 66 are alternately connected to one output terminal 7 and the other output terminal 8.

In Fig. 4, one primary electrode 5' has been moved away from the insulating layer 1 so as to reduce the mechanical stresses during the polarisation. Unlike the insulating layer 1, the ceramics is subjected to dimensional changes during the polarisation.

Fig. 5 illustrates an alternative positioning of the primary electrodes on the inner side and the outer side, respectively, of the annular body 2. The secondary electrodes 6a, 6b are positioned in the same position as in Figs. 3 and 4.

Fig. 6 illustrates an alternative positioning of the primary electrodes, where the inner electrode has been withdrawn so as to reduce the polarisation stresses.

Fig 7 illustrates an alternative embodiment of the piezoelectric body. The piezoelectric material is preferably a PZT ceramics. PZT is preferred because it presents an increased dielectricity constant and an increased coupling coefficient.

The transformer can for instance be used for transforming 120 VAC into 12 VAC. The piezoelectric transformer presents a relatively high energy density, viz. up to 0.04 W/cm$^3$ kHz corresponding to a field intensity of 20 W/cm$^3$ at 500 kHz. Thus the component is suited for miniaturising.

Other things being equal, the latter results in a comparatively smaller component, which in turn involves a reduced cost price. The increased operating frequency has also the effect that filter components (coils, capacitors) of the associated structure can present lower values and consequently a reduced physical size as well as a reduced price.

The insulation between the primary and the secondary portions depends no longer on the leakage path along the surface of the transformer, but on the breakdown voltage in the insulating layer. Therefore the reduced dimensions present no hindrance to meet the same or higher requirements to the insulation.

The operating frequency is typically 500 kHz. The piezoelectric material can be Navy type 1. The external diameter is 10 mm, whereas the internal diameter is 7 mm. Each part is of a length of 1.8 mm, and the two parts are separated by a round aluminium disk of a thickness of 0.25 mm. The total length of the transformer is 3.85 mm.

Nothing but transformers have been discussed until now where one part is a multilayer component while the other part is a bulk component. It is, however, also possible that both components are either bulk or multilayer components in response to the desired voltage ratio and the impedance conditions to which the transformer is to be adapted. The bulk components are less expensive and it is possible to obtain a voltage ratio of up to 1: 3 by employing materials presenting a varying permittivity on the primary and the secondary portions.

Furthermore it is possible to use an either triangular or quadrangular blank with a round opening instead of the cylindrical blank, of. Fig. 8. The opening is asymmetrically positioned so as to further attenuate undesired resonances. Quadrangles can be cut out in a cost-saving manner, and it is easy to drill round openings.

## Claims

1. Piezoelectric transformer comprising a substantially piezoelectric body which is divided into a primary portion (2) and a secondary portion (3), both the primary portion and the secondary portion being able to generate and transform piezoelectric vibrations in accordance with an AC-voltage fed to one portion while a transformed voltage can be delivered from the other portion, **characterised in that** the piezoelectric body is constituted by a substantially annular body, which has been polarised substantially perpendicular to a peripheral direction of the annular body.

2. A piezoelectric transformer according to claim 1, wherein the substantially annular body is an annular body.

3. A piezoelectric transformer according to claim 1, wherein the annular piezoelectric body has been polarized in the longitudinal direction.

4. A piezoelectric transformer as claimed in claim 1, wherein the primary portion of the annular piezoelectric body has been substantially radially polarised.

5. A piezoelectric transformer according to claim 1 for 2, wherein the transformer is operated at a thickness resonance frequency.

6. A piezoelectric transformer according to claim 1 or 2, wherein the ratio b/h between the width b of the wall of the annular body and the height h of the wall of the annular body is either at the most 0.25 or in the range between 0.35 and 0.8.

7. A piezoelectric transformer according to claim 6, wherein the ratio b/h is between 0.4 and 0.7.

8. A piezoelectric transformer according to any of the preceding claims, wherein a portion of the piezoelectric transformer is a multilayer structure.

9. A piezoelectric transformer according to any of the preceding claims, wherein the piezoelectric material is a PZT ceramic.

## Patentansprüche

1. Piezoelektrischer Wandler mit einem im Wesentlichen piezoelektrischen Körper, der in einen ersten Bereich (2) und in einen zweiten Bereich (3) unterteilt ist, wobei sowohl der erste Bereich als auch der zweite Bereich dazu eingerichtet sind, entsprechend einer in einem Bereich ausgeprägten Wechselspannung piezoelektrische Schwingungen zu erzeugen und zu wandeln, während eine transformierte Spannung von dem anderen Bereich lieferbar ist, **dadurch gekennzeichnet, dass** der piezoelektrische Körper durch einen im Wesentlichen ringförmigen Körper gebildet ist, der im Wesentlichen rechtwinklig zu einer Umfangsrichtung des ringförmigen Körpers polarisiert ist.

2. Piezoelektrischer Wandler nach Anspruch 1, bei dem der im Wesentlichen ringförmige Körper ein ringförmiger Körper ist.

3. Piezoelektrischer Wandler nach Anspruch 1, bei dem der ringförmige piezoelektrische Körper in der Längsrichtung polarisiert ist.

4. Piezoelektrischer Wandler nach Anspruch 1, bei dem der erste Bereich des ringförmigen piezoelektrischen Körpers im Wesentlichen radial polarisiert worden ist.

5. Piezoelektrischer Wandler nach Anspruch 1 oder 2, bei dem der Wandler bei einer Dickenresonanzfrequenz betrieben ist.

6. Piezoelektrischer Wandler nach Anspruch 1 oder 2, bei dem das Verhältnis b/h zwischen der Breite b der Wand des ringförmigen Körpers und der Höhe h der Wand des ringförmigen Körpers entweder höchstens 0,25 beträgt oder in dem Bereich zwischen 0,35 und 0,8 liegt.

7. Piezoelektrischer Wandler nach Anspruch 6, bei dem das Verhältnis b/h zwischen 0,4 und 0,7 liegt.

8. Piezoelektrischer Wandler nach einem der vorangehenden Ansprüche, wobei ein Bereich des piezoelektrischen Wandlers eine Mehrlagenstruktur ist.

9. Piezoelektrischer Wandler nach einem der vorangehenden Ansprüche, bei dem das piezoelektrische Material eine PZT-Keramik ist.

## Revendications

1. Transformateur piézoélectrique comprenant un corps sensiblement piézoélectrique qui est divisé en une partie primaire (2) et en une partie secondaire (3), tant la partie primaire que la partie secondaire étant susceptibles de produire et de transformer des vibrations piézoélectriques selon une tension en courant alternatif amenée à une partie tandis qu'une tension transformée peut être délivrée en provenance de l'autre partie, **caractérisé en ce que** le corps piézoélectrique est constitué par un corps sensiblement annulaire, qui a été polarisé sensiblement perpendiculairement à une direction périphérique du corps annulaire.

**2.** Transformateur piézoélectrique selon la revendication 1, dans lequel le corps sensiblement annulaire est un corps annulaire.

**3.** Transformateur piézoélectrique selon la revendication 1, dans lequel le corps piézoélectrique annulaire a été polarisé dans la direction longitudinale.

**4.** Transformateur piézoélectrique selon la revendication 1, dans lequel la partie primaire du corps piézoélectrique annulaire a été polarisée de façon sensiblement radiale.

**5.** Transformateur piézoélectrique selon la revendication 1 ou 2, dans lequel le transformateur est mis en oeuvre à une fréquence de résonance d'épaisseur.

**6.** Transformateur piézoélectrique selon la revendication 1 ou 2, dans lequel le rapport b / h entre la largeur b de la paroi du corps annulaire et la hauteur h de la paroi du corps annulaire est soit de 0,25 au maximum soit dans la plage comprise entre 0,35 et 0,8.

**7.** Transformateur piézoélectrique selon la revendication 6, dans lequel le rapport b / h est compris entre 0,4 et 0,7.

**8.** Transformateur piézoélectrique selon l'une quelconque des revendications précédentes, dans lequel une partie du transformateur piézoélectrique est une structure à plusieurs couches.

**9.** Transformateur piézoélectrique selon l'une quelconque des revendications précédentes, dans lequel la matière piézoélectrique est une céramique PZT.

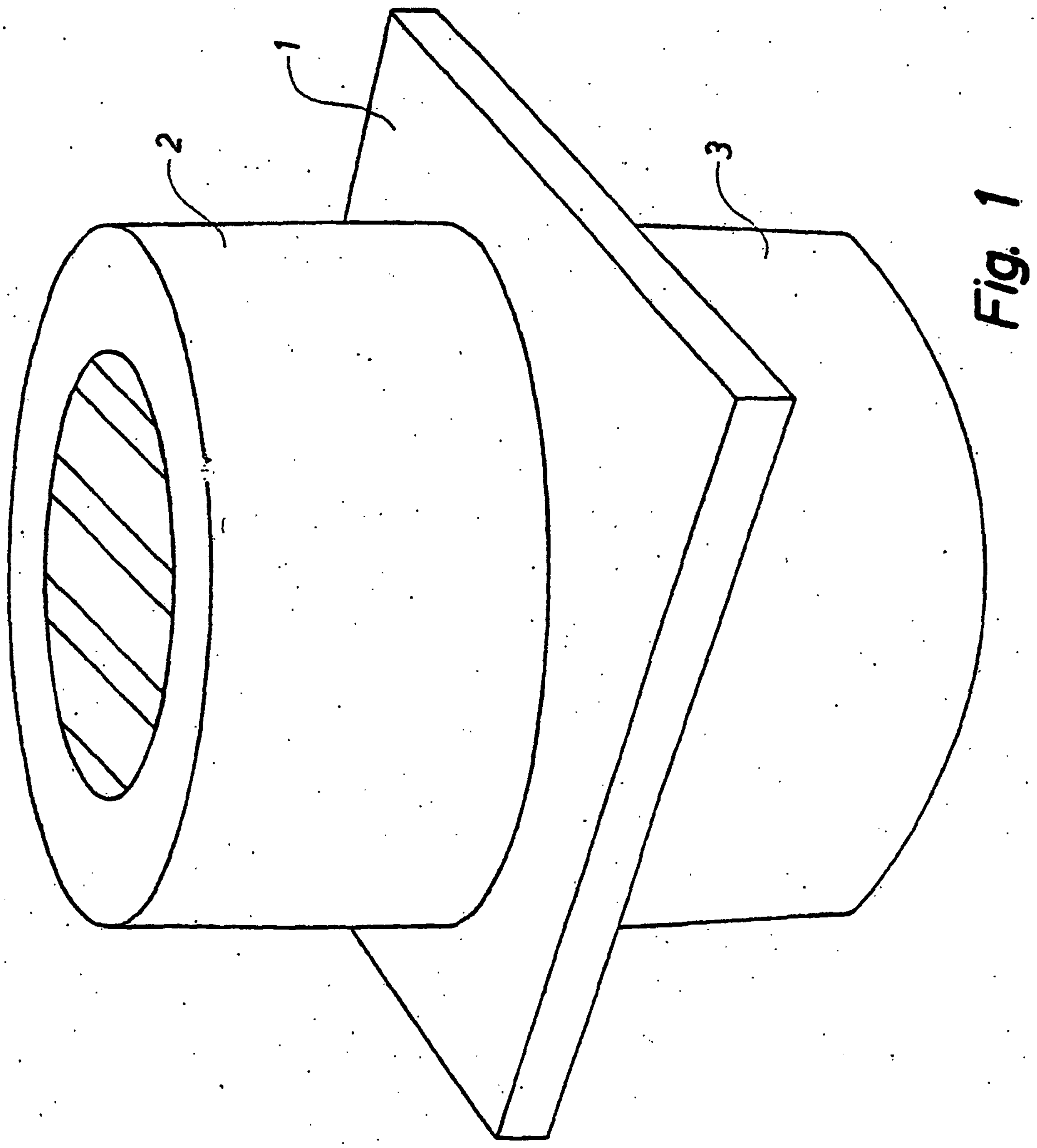


Fig. 1

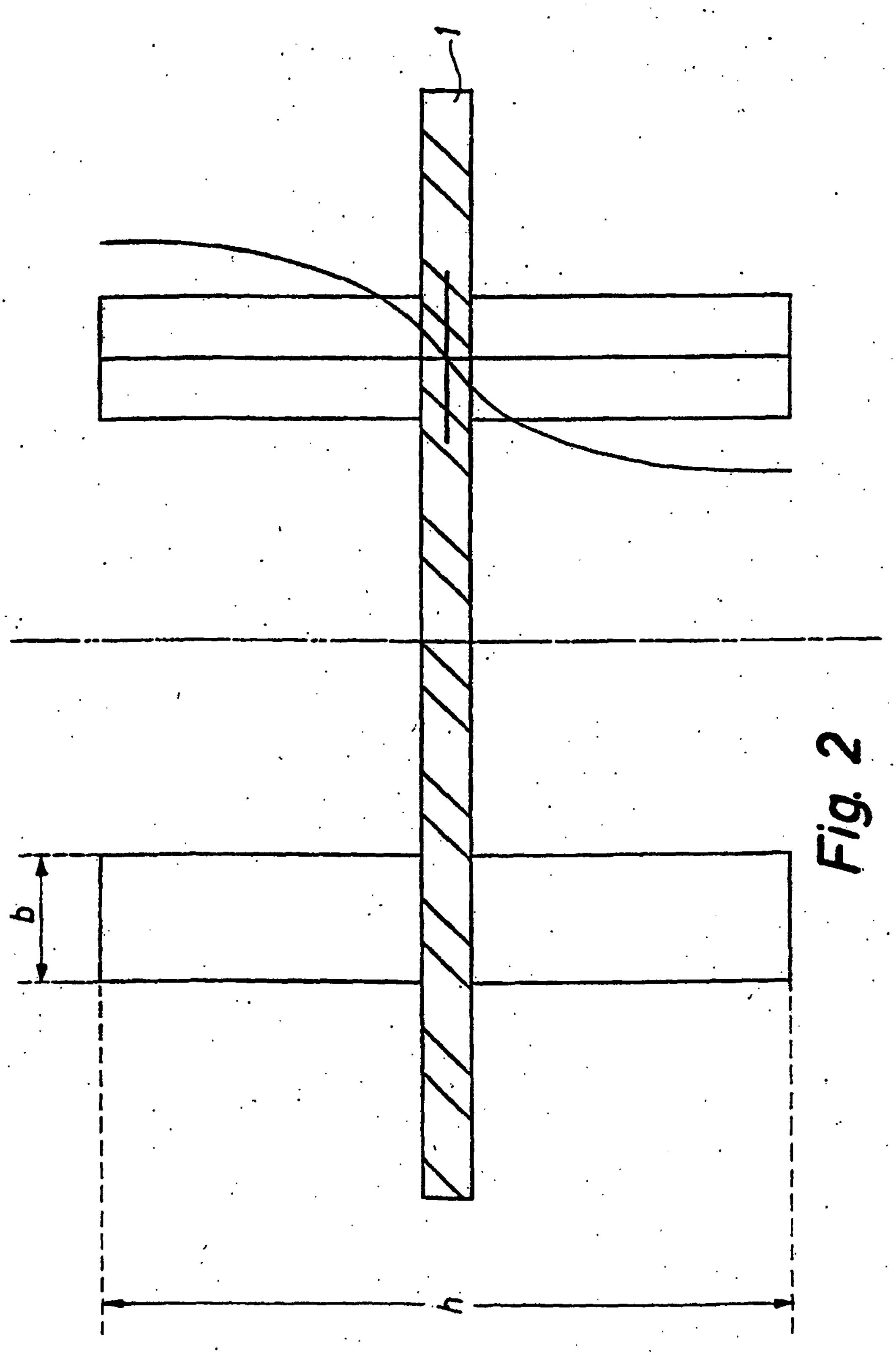


Fig. 2

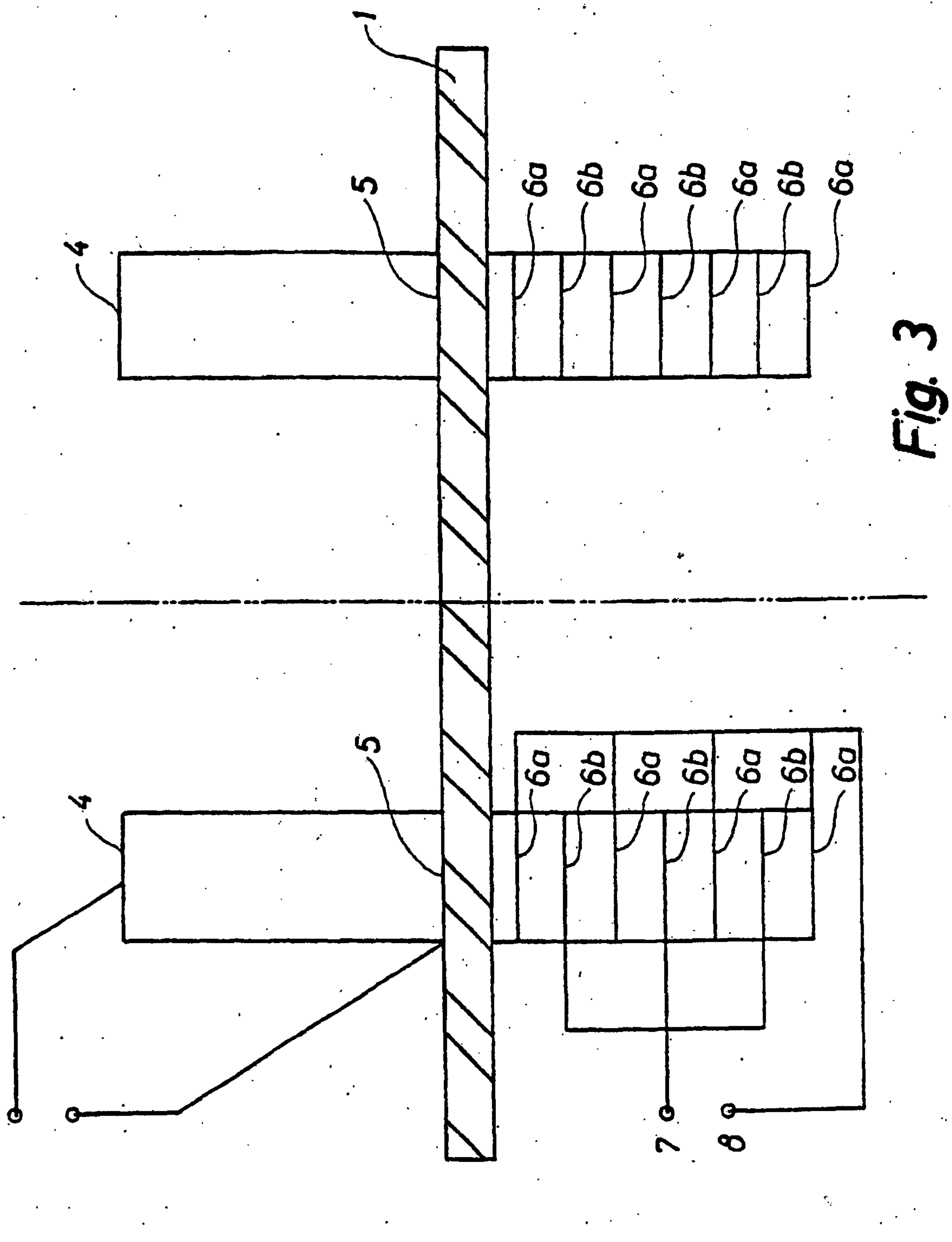


Fig. 3

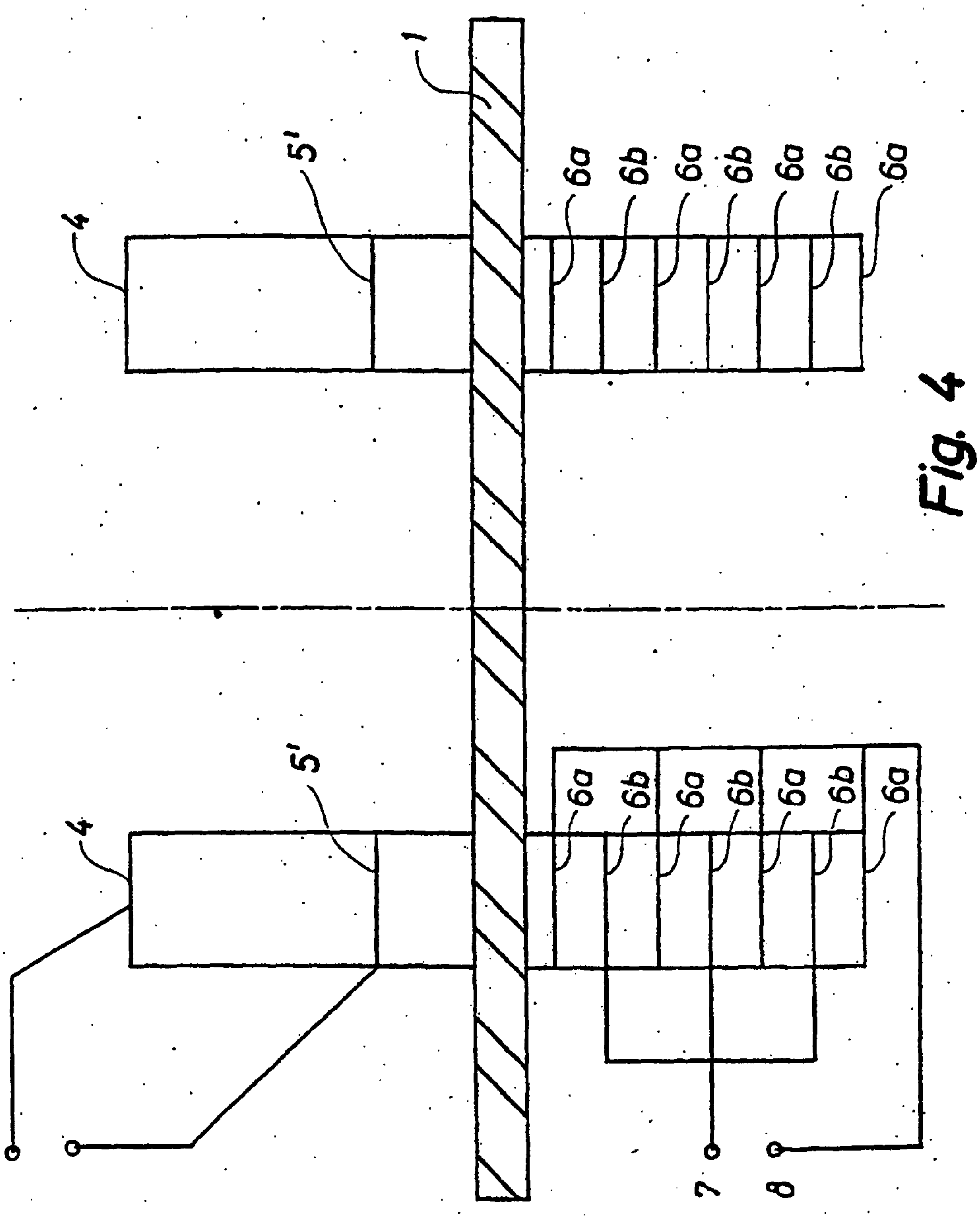


Fig. 4

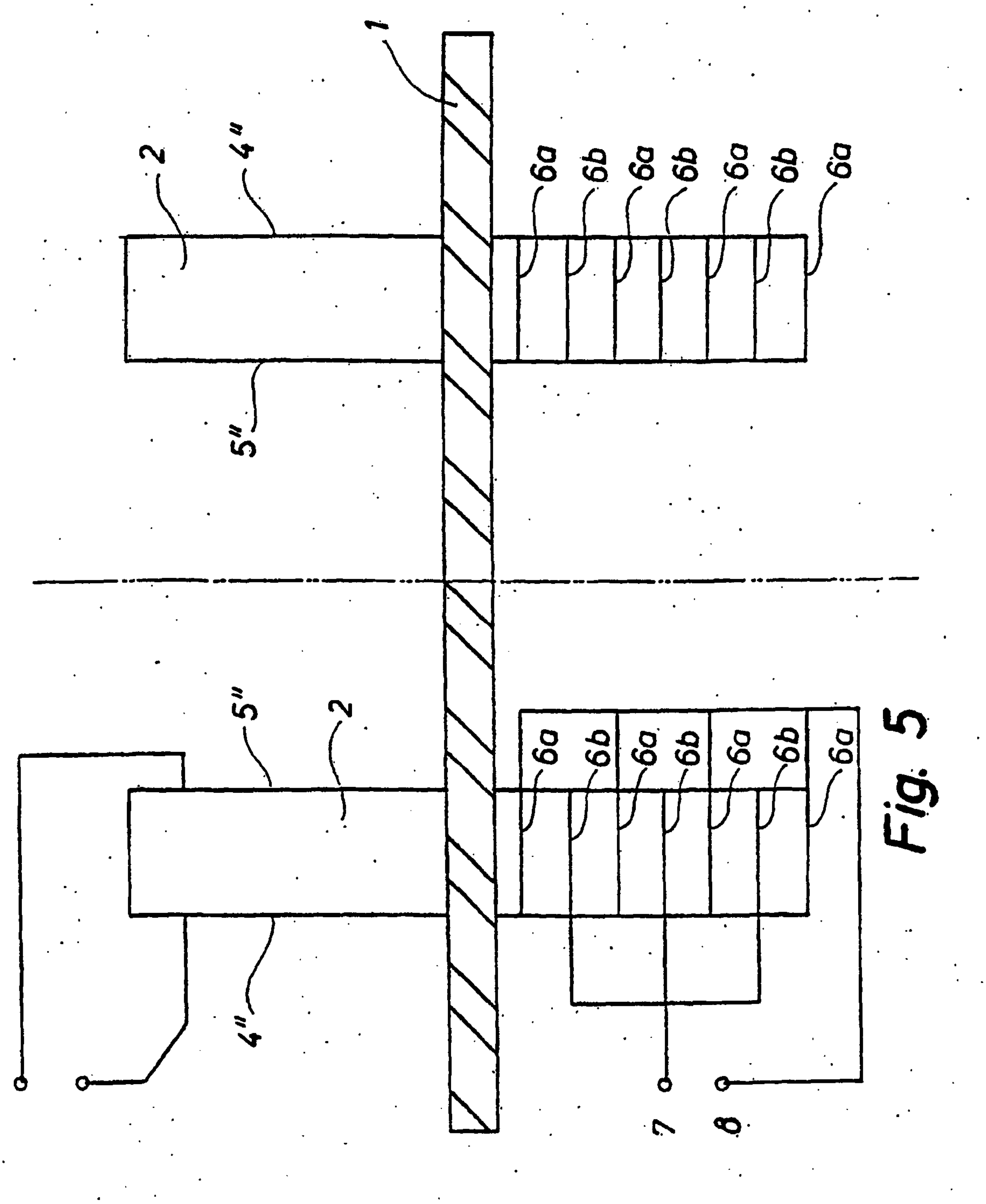


Fig. 5

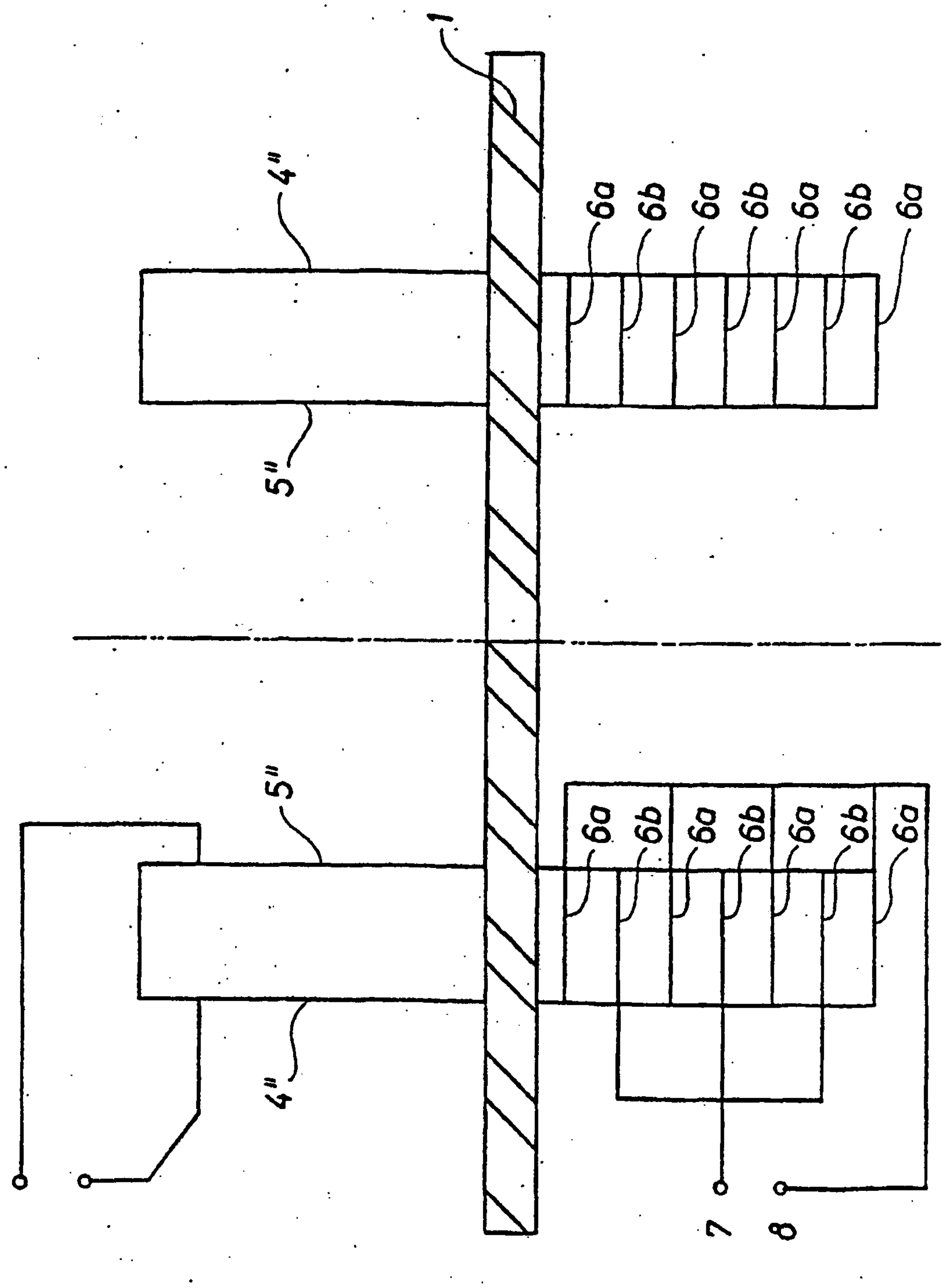


Fig. 6

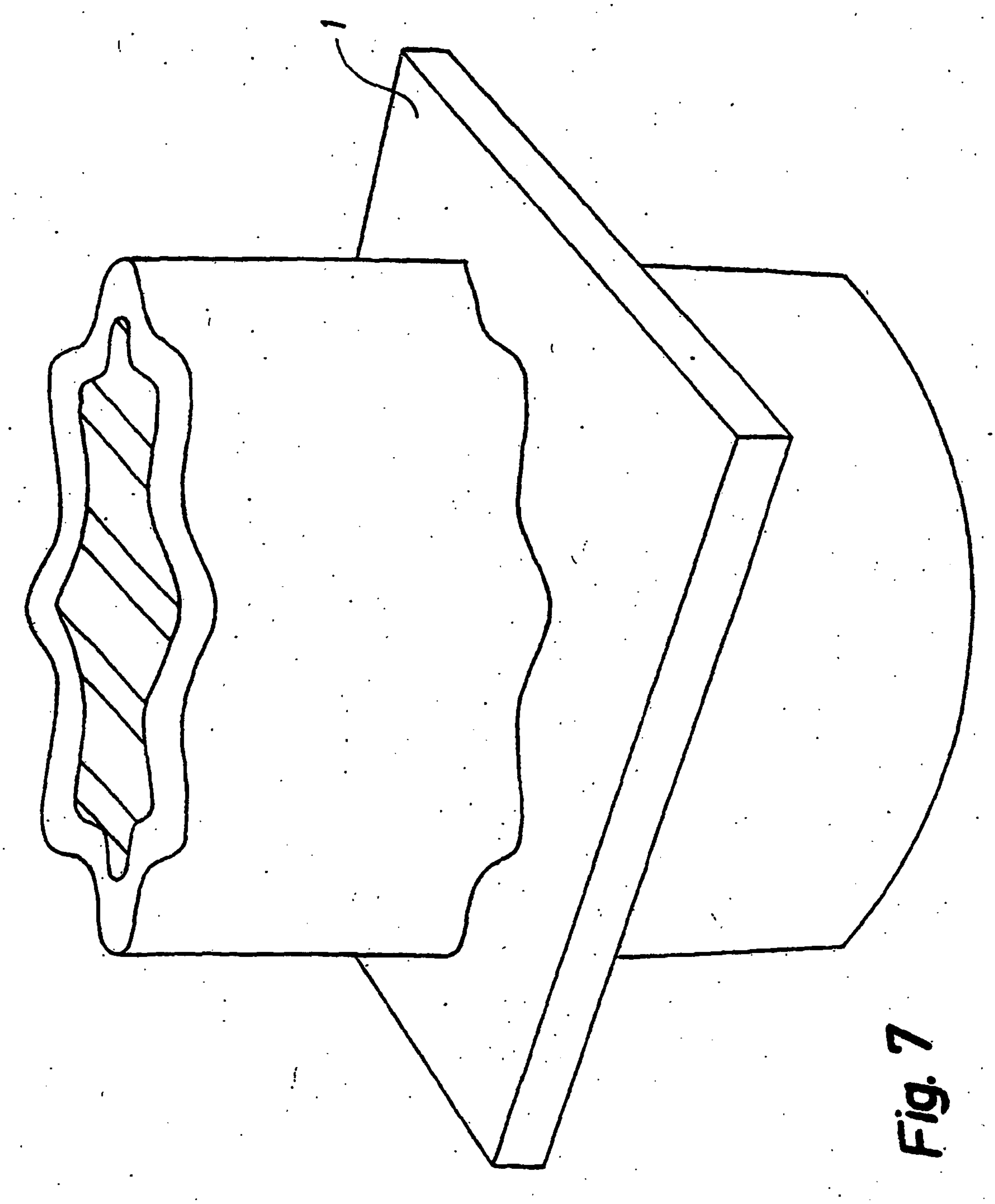


Fig. 7

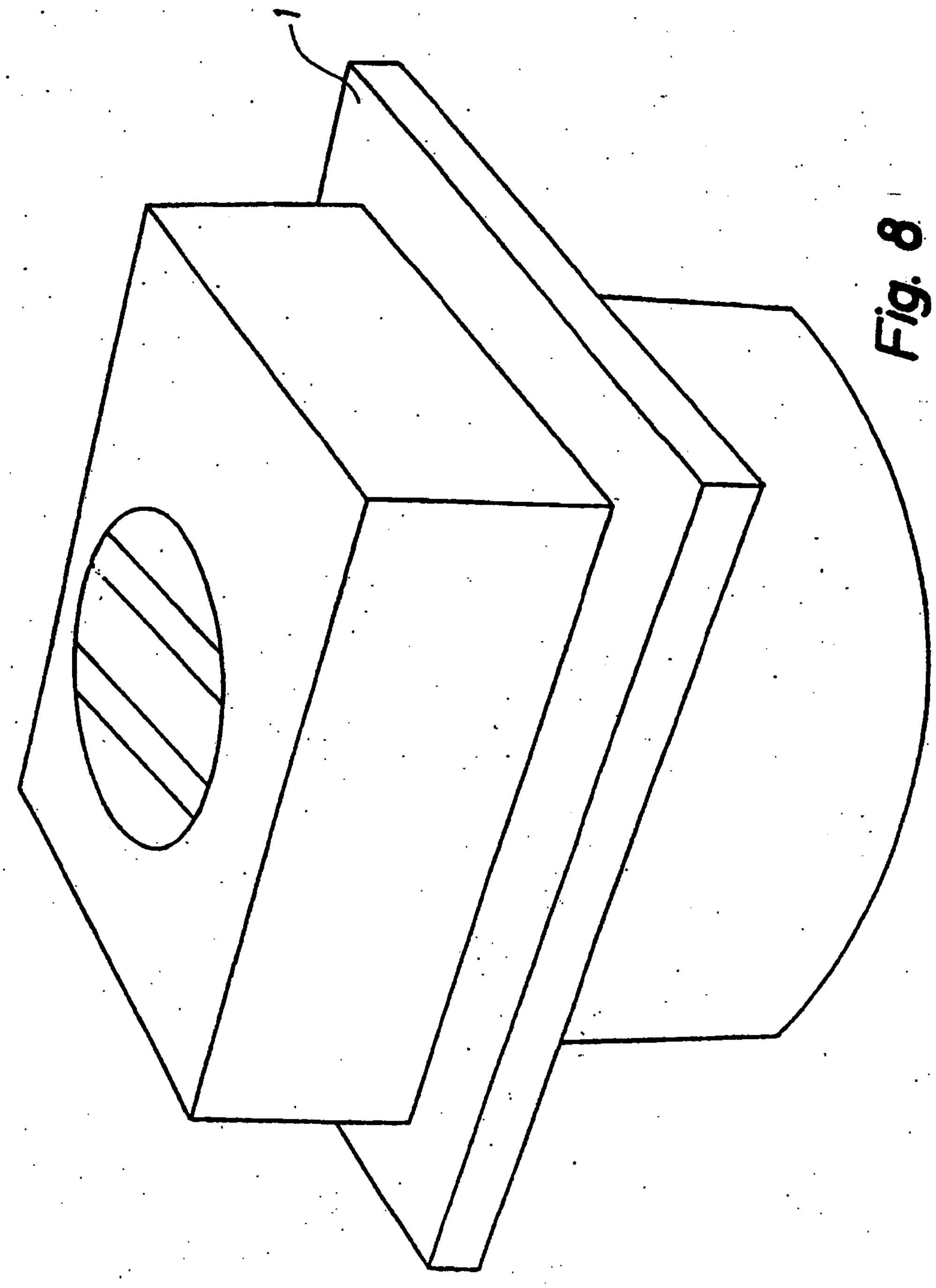

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 3736446 A
- JP 9321363 A